# EUROPÄISCHE PATENTANMELDUNG

(11) **EP 0 997 551 A2**
(43) Veröffentlichungstag der Anmeldung: **03.05.2000**
(21) Anmeldenummer: 99121114.5
(22) Anmeldetag: 22.10.1999
(51) Int. Cl.: C23C 14/08, C23C 14/00, B65B 1/00

(54) **Transparentes Barriereschichtensystem**

(30) Priorität: 26.10.1998 DE 19849205
(71) Anmelder: Leybold Systems GmbH, 63450 Hanau (DE)
(72) Erfinder: Grimm, Helmut, Dr., 64291 Darmstadt (DE); Henrich, Jürgen, 63694 Limeshain (DE); Rödling, Gert, 63179 Obertshausen (DE); Ulrich, Jürgen, 61137 Schöneck (DE); Helle, Franz-Josef, 63477 Maintal (DE); Honekamp, Jürgen, 63457 Hanau (DE); Schmidt, Frank, 63477 Maintal (DE)

(57) **Zusammenfassung**

Ein auf einem Kunststoffsubstrat abgeschiedenes, aus mindestens zwei optisch transparenten Einzelschichten bestehendes Schichtensystem weist eine erste, auf dem Substrat abgeschiedene Siliziumoxidschicht SiOₓ und eine auf die SiOₓ-Schicht abgeschiedene zweite, Metalloxidverbindungen aufweisende Einzelschicht auf. Die SiOₓ-Schicht bewirkt die Haftung des Schichtensystems auf dem Substrat (2), wohingegen die zweite Einzelschicht (5) die Permeation von gasförmigen Substanzen durch die beschichtete Substratgrenzfläche verhindert und als Barriereschicht wirkt.

## Beschreibung

Die Erfindung betrifft ein für sichtbares Licht transparentes Barriereschichtensystem auf Kunststoffsubstraten, welches die Permeation von gasförmigen und/oder flüssigen Stoffen, insbesondere von Kohlenwasserstoffen, Sauerstoff, Wasserdampf und von CO₂ durch das beschichtete Substrat hemmt.

Aus Kunststoffen bestehende Verpackungen oder Behälter, in welchen leicht flüchtige Substanzen wie Kohlenwasserstoffe oder Aromen und Duftstoffe transportiert und gelagert werden, sind bekannterweise nicht ausreichend diffusionsdicht, um ein Austreten dieser Substanzen aus dem Behälter zu unterbinden. Insbesondere Gase, wie z. B. niedermolekulare Kohlenwasserstoffe, Sauerstoff, Kohlendioxid und Wasserdampf, können durch dünnwandige Verpackungen, wie z. B. Folien oder unter erhöhtem Innendruck stehende Behälter aus Kunststoff, in welchen z. B. CO₂-haltige Erfrischungsgetränke gelagert und transportiert wird, hindurchdiffundieren. Durch das Austreten der vorgenannten Substanzen aus dem Behälterinneren verändert sich die chemische Zusammensetzung des Behältergutes nachteilig, wodurch dieses insgesamt für seinen vorgesehenen Verwendungszweck nicht mehr brauchbar ist.

Zur Vermeidung derartiger Nachteile ist bekannt, gattungsgemäß zu verwendende Kunststoffverpackungen mit Diffusionsbarriereschichten zu versehen. Optisch transparente Barriereschichten werden üblicherweise durch Aufdampfen von Metalloxiden, insbesondere von Al₂O₃, oder durch reaktives Aufdampfen der Metallanteile zur Bildung einer Metalloxidschicht auf Substratoberflächen hergestellt.

Als Alternative hierzu sind auch quarzähnliche stöchiometrische SiO₂-Schichten bekannt, welche durch einen plasmachemischen Gasphasenabscheidungsprozeß (Plasma-Chemical-Vapour-Deposition, PCVD) aus einer reaktiven Siliziumdampf-Sauerstoffgas-Atmosphäre mit einem Überschuß an Sauerstoff auf dem Substrat zur Bildung einer Barriereschicht aufgetragen werden.

In der PCT-US 97/05061 wird z. B. die Herstellung von Barriereschichten gegen Sauerstoff, Wasserdampf und Kohlendioxid beschrieben, wobei ein Kunststoffmaterial mit amorphem Nylon vorbeschichtet wird und anschließend durch ein PCVD-Verfahren mit einer Silizium- oder Aluminiumoxidschicht oder einer Mischung hieraus beschichtet wird.

Nach der EP 0 460 796 A2 wird die Barrierewirkung einer mit einem Vakuumverfahren, nämlich durch Bedampfen und Kathodenzerstäubung aufgebrachten, glasartigen, in ihrer Verbindung stöchiometrischen SiO₂-Schicht gegen Sauerstoff- und Wasserstoffpermeation verbessert, indem mindestens ein Metall aus der Gruppe Antimon, Aluminium, Chrom, Kobalt, Kupfer, Indium, Eisen, Blei, Mangan, Zinn, Titan, Wolfram, Zink und Zirkonium in die Barriereschicht eingelagert wird. Die SiO₂-Schicht wird dabei in einer Dicke von mindestens 20 nm bis etwa 500 nm unmittelbar auf dem Substrat selbst abgeschieden.

In der DE 44 04 690 A1 wird ein Verfahren zur Erzeugung von Sperrschichten auf Kunststoffsubstraten gegen Gase und Dämpfe angegeben, bei welchem ein Schichtensystem aufgebracht wird, welches aus mindestens zwei Schichten, nämlich mindestens einer Grundschicht und einer Deckschicht besteht. Hierbei wird die Grundschicht als siliziumorganische, also kohlenstoffhaltige Schicht mittels PCVD-Verfahren aus einem siliziumhaltigen Reaktivgas und die Deckschicht mit einem beliebigen Vakuumbeschichtungsverfahren, wie z. B. durch Aufdampfen, Kathodenzerstäubung oder bevorzugt durch PCVD, als kohlenstoffarme Metalloxidschicht aufgebracht. Zur Durchführung der PCVD-Prozesse wird dem Plasma durch Einwirkung elektromagnetischer, mit einem Radiofrequenzmagnetron erzeugter Strahlung Energie zugeführt.

In der DE 44 38 359 A1 wird ein gattungsähnliches, auf Kunststoffbehältern aufgebrachtes Schichtensystem beschrieben, das sich aus sequentiell angeordneten organischen und auch siliziumorganischen Polymeren sowie aus anorganischen Oxiden zusammensetzt. Die Schichten werden mittels physikalischer Gasphasenabscheidung ("Physical-Vapour-Deposition", PVD) oder PCVD, insbesondere PICVD ("Plasma-Impulse-Chemical-Vapour-Deposition") hergestellt, wobei das Plasma durch Mikrowellen angeregt wird.

Den vorgenannten Verfahren ist gemeinsam, daß die Sperrschichten im wesentlichen stöchiometrisches SiO₂ enthalten, das sich nachteilig nicht mit den erforderlichen hohen Beschichtungsraten aufbringen läßt, um kurze Beschichtungszeiten zu gewährleisten. Einzelbarriereschichten, welche im wesentlichen SiO₂ enthalten, weisen, wie die Praxis gezeigt hat, auch keine ausreichende, langanhaltende Barrierewirkung insbesondere gegen CO₂ auf. Um diese Nachteile von SiO₂-Barriereschichten auszugleichen, werden diese üblicherweise mit einer größeren Schichtdicke auf dem Substrat aufgebracht. Dies hat jedoch den Nachteil, daß diese dann glasartigen SiO₂-Schichten mit zunehmender Schichtdicke stoßempfindlicher werden und beim Transport der beschichteten Behältersubstrate beschädigt, insbesondere brüchig werden, wodurch die Barrierewirkung zunehmend aufgehoben ist.

Der Erfindung liegt die Aufgabe zugrunde, eine Barriereschicht zu schaffen, die sowohl eine erhöhte Sperrwirkung im Vergleich zu den aus dem Stand der Technik bekannten Barriereschichten aufweist, optisch transparent und auch unempfindlich gegenüber mechanischen Einwirkungen ist. Weiterhin soll ein Verfahren angegeben werden, mittels welchem die Herstellung einer transparenten, reißfesten, insbesondere mechanisch stabilen und eine hohe Sperrwirkung gegenüber dem Durchtritt von gasförmigen und/oder flüssigen Substanzen, wie z. B. Sauerstoff, Wasserdampf, insbesondere Kohlenwasserstoff und Kohlendioxid, Barriereschicht auf Kunststoffmaterialien möglich ist.

Erfindungsgemäß wird die Verfahrensaufgabe dadurch gelöst, daß mittels eines plasmagestützten Gasphasenabscheideverfahrens ein Barriereschichtensystem auf Substraten durch nacheinander Aufdampfen von mindestens zwei Einzelschichten aufgebracht wird, wobei die erste, unmittelbar auf dem Substrat aufgetragene Einzelschicht eine optisch transparente Siliziumoxidschicht (SiOₓ) ist mit einer stöchiometrischen Zusammensetzung von x < 2 und in einer Schichtdicke < 500 nm. Auf diese erste Einzelschicht wird nachfolgend eine mindestens eine Metalloxidverbindung aufweisende, optisch transparente Einzelschicht in einer Schichtdicke von bis zu 500 nm aufgedampft.

Diese erfindungsgemäße Schichtenkombination aus einer SiOₓ-Schicht und Metalloxidschicht als Deckschicht hat sich in der Praxis als einerseits sehr haftbeständig und andererseits eine hohe Barrierewirkung aufweisendes Schichtensystem erwiesen. Als Grund hierfür wird vermutet, daß die SiOₓ-Schicht eine auf Kunststoffsubstraten ausgewiesen hohe Haftfestigkeit aufweist. Andererseits haften metallhaltige, insbesondere dünne Metalloxidschichten beständig und fest auf der ersten SiOₓ-Einzelschicht. Als vorteilhaft hat es sich hierbei erwiesen, daß die erste Einzelschicht mit einer Dicke < 20 nm auf der Substratoberfläche aufgetragen wird. Dies hat den Vorteil, daß die dünne SiOₓ-Schicht gegen äußere, mechanische Einwirkungen flexibel verformbar bleibt, wodurch ein Aufbrechen und Lösen dieser Haftfunktionsschicht von dem Substrat wie bei SiO₂-Schichten größer als 300 nm beobachtet, welche eine größere Dicke besitzen und glasartig auf mechanische Stoßbelastungen reagieren, nicht eintritt. Die hohe Barrierewirkung des erfindungsgemäßen Schichtensystems wird im wesentlichen durch die zweite Einzelschicht erzielt.

Diese zweite Einzelschicht wird als Metalloxidschicht abgeschieden, welche eine hohe Lichttransmission aufweist. Diese zweite Einzelschicht wird erfindungsgemäß in einer Dicke von 10 nm bis 500 nm, vorzugsweise von 30 nm bis 50 nm auf der ersten Schicht abgeschieden.

Hierzu wird vorgeschlagen, die zweite Einzelschicht durch ein reaktives Abscheideverfahren abzuscheiden. Hierzu wird während des Beschichtungsprozesses dem verdampften und auf dem Substrat sich niederschlagenden Metalldampf Sauerstoff zugeführt, wodurch sich die zweite Einzelschicht als chemisch reaktiv entstandene Metalloxidschicht auf dem Substrat niederschlägt.

Sowohl die SiOₓ-Schicht als auch die Metalloxidschicht sind im optischen Spektralbereich transparent, wodurch ein im optischen Wellenlängenbereich insgesamt transparentes Barriereschichtensystem auf dem Substrat abgeschieden wird. Dies hat den Vorteil, daß erfindungsgemäße Barriereschichten, welche auf optisch transparenten Substraten aufgebracht sind, die Sicht auf hinter oder innerhalb eines als Gefäß ausgebildeten Substrates ermöglichen.

Weiterhin wird erfindungsgemäß vorgeschlagen, optional auf die metallhaltige, zweite Einzelschicht eine dritte, Siliziumanteile, vorzugsweise Siliziumoxid aufweisende Einzelschicht in einer Schichtdicke bis maximal 500 nm abzuscheiden. Als besonders vorteilhaft hat sich herausgestellt, diese Schicht als stöchiometrische SiO₂-Schicht abzuscheiden. Diese chemisch inerte Schutzschicht hat sich als kratzfest sowie laugen- und säurefest erwiesen. Bei kleineren Schichtdicken, insbesondere < 20 nm bleibt diese Deckschicht auch bei mechanischer Einwirkung, z. B. beim Transport von beschichteten Behältern ausreichend elastisch verformbar, wodurch ein Aufreißen bzw. brüchig werden der SiOₓ-Deckschicht nicht eintritt. Hierdurch kann die SiOₓ-Deckschicht ihre Schutzwirkung für die darunter liegenden Funktionsschichten dauerhaft erfüllen.

Alternativ zu einem aus zwei oder drei Einzelschichten aufgebauten Schichtensystem sind zwischen den Einzelschichten ausgebildete Übergangsschichten vorgesehen, innerhalb deren die Mengenkonzentration beim Übergang von einer Einzelschicht in die benachbarte Einzelschicht graduell zu- bzw. abnimmt. Diese Zwischenschichten weisen Anteile von Siliziumoxid und Metalloxid gleichzeitig auf, wobei die Siliziumoxidkonzentration in Richtung der Metalloxidschicht abnimmt und die Metalloxidkonzentration in Richtung der Metalloxidschicht zunimmt.

Als vorteilhaft hat sich herausgestellt, die stöchiometrische Zusammensetzung der einzelnen Elementverbindungen in der Zwischenschicht derartig einzustellen, daß die Siliziumverbindungen als SiOₓ mit 1 ≤ x ≤ 2 abgeschieden werden. Metalloxidische Komponenten, die als Aluminiumoxid abgeschieden werden, weisen stöchiometrische Zusammensetzungen der Darstellung Al_{y}O_{z} mit 1,5 ≤ y ≤ 2 und 2 ≤ z ≤ 3 auf.

Ein erfindungsgemäß hergestelltes Barriereschichtensystem wird im folgenden anhand in Figuren dargestellter und besonders bevorzugter Ausführungsbeispiele näher erläutert. Es zeigen:
- Fig. 1: eine Querschnittsansicht einer erfindungsgemäßen zweilagigen Barriereschicht auf einem Kunststoffsubstrat,
- Fig. 2: die Querschnittsansicht einer erfindungsgemäßen, aus drei Einzelschichten bestehenden Barriereschicht auf einem Substrat und
- Fig. 3: eine Querschnittsansicht einer aus drei Einzelschichten und einer Zwischenschicht bestehenden Barriereschicht auf einem Substrat nach einem dritten Ausführungsbeispiel.

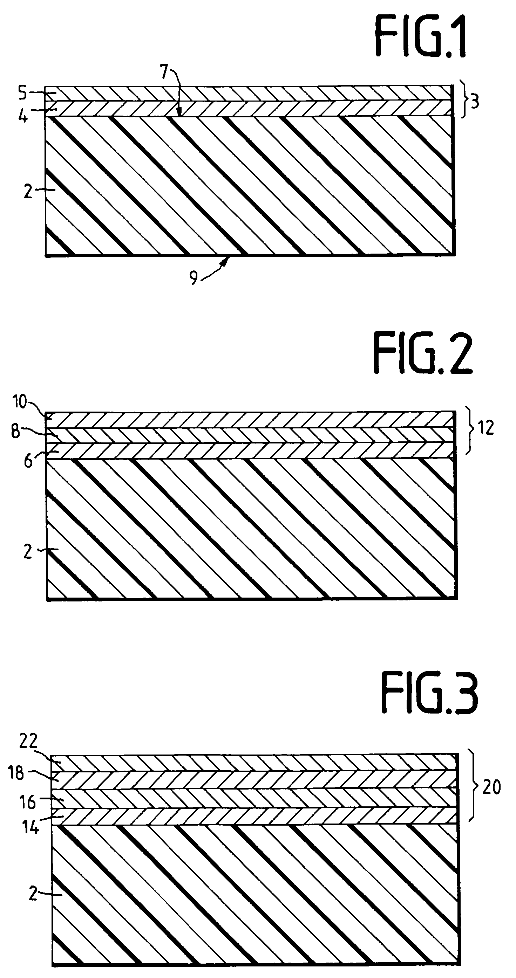

Das in Figur 1 dargestellte Barriereschichtensystem 3 besteht aus zwei Einzelschichten 4,5, welche mittels eines PCVD (Plasma-Chemical-Vapour-Deposition)-Beschichtungsverfahrens auf einem Kunststoffsubstrat 2 abgeschieden sind. Das Kunststoffsubstrat 2 besteht aus Polyethylenterephthalat (PET), welches zur Herstellung von Getränkeflaschen verwendet wird. Auf die Substrataußenfläche 7 wird in einem ersten Verfahrensschritt mittels des PCVD-Beschichtungsverfahrens die erste Einzelschicht 4 großflächig als zusammenhängende Schicht abgeschieden. Die Schicht 4 besteht im wesentlichen aus einer Siliziumoxidverbindung, wobei das Siliziumoxid (SiOₓ) in dem stöchiometrischen Wertebereich x < 2 abgeschieden wird. Hierzu wird die zu beschichtende Substratfläche 7 einer Siliziumdampf und Sauerstoffgas enthaltenden Gaswolke ausgesetzt. Der Beschichtungsprozeß wird in einer Vakuumbeschichtungskammer bei einem Totaldruck < 10⁻² hPa durchgeführt, in welcher die aufzudampfenden Schichtsubstanzen in einzelnen Tiegeln auf ihre Verdampfungstemperatur erwärmt werden. Das zu beschichtende Substrat 2 wird in Abfolge der aufzubringenden Einzelschichten 4,5 (in Fig. 1); 6,8,10 (in Fig. 2); 14,16,18 (in Fig. 3) über und entlang der Tiegelöffnungen transportiert, wobei das verdampfte und sich als Materialwolken über den Tiegeln räumlich verteilte Schichtmaterial Silizium auf der Substratoberfläche 7 zu einer jeweils zusammenhängenden SiOₓ-Schicht reaktiv kondensiert.

Das in Figur 1 dargestellte Schichtensystem 3 besteht aus insgesamt zwei Einzelschichten 4,5, nämlich aus der Haftschicht 4, welche im wesentlichen aus Siliziumoxid (SiOₓ) mit 1 ≤ x < 2 besteht, und einer abschließenden zweiten Schicht 5 aus Aluminiumoxid (Al₂O₃). Zur Herstellung der Siliziumoxidbzw. Aluminiumoxidschicht wird in die Vakuumkammer ein Sauerstoffgas eingelassen, welches mit dem verdampften Siliziummaterial bzw. Aluminium unmittelbar vor Abscheiden auf der Substratoberfläche zu Siliziumoxidₓ bzw. Aluminiumoxid chemisch verbindet und auf dem Substrat 2 niederschlägt. Die Schichtdicke der Einzelschicht 4 beträgt ca. 15 nm und die Schichtdicke der Al₂O₃-Schicht 5 30 nm - 50 nm, vorzugsweise ca. 40 nm.

Zur Erhöhung der mechanischen und chemischen Widerstandsfähigkeit des Barriereschichtsystems 12 (siehe Figur 2) wird auf die aus der ersten Einzelschicht 6 und der zweiten Einzelschicht 8 bestehende Schichtenfolge eine Schutzschicht 10 aufgetragen. Die Schutzschicht 10 besteht, ähnlich wie die Haftschicht 6, aus Siliziumoxid (SiOₓ) mit 1 ≤ x ≤ 2. Die Schichtdicke d₁ der Einzelschicht 6 beträgt ca. 15 - 18 nm, die Schichtdicke d₂ der Einzelschicht 8 ca. 30 - 50 nm und die Schichtdikke d₃ der Deck- und Schutzschicht 10 ca. 15 - 18 nm.

Das in Figur 3 dargestellte Schichtensystem weist ebenfalls eine auf einem Kunststoffsubstrat 2 aufgetragene SiOₓ-Schicht mit 1 ≤ x < 2 und eine auf die als Haftschicht dienende erste Schicht 14 aufgetragene zweite Einzelschicht 16 auf, welche allerdings abweichend von den in den Figuren 1 und 2 dargestellten Ausführungsbeispielen aus einem Metall, vorzugsweise aus Aluminium bzw. Kupfer oder einer Aluminium-Kupfer-Legierung besteht. Diese Metallschicht 16 wird durch eine darüberliegende SiOₓ-Einzelschicht 18 mit 1,5 < x < 2 vollständig bedeckt. Hierdurch wird die duktil weichere Metallschicht 16 durch die glasartige und ca. 15 - 18 nm dicke Deckschicht 18 gegenüber äußeren mechanischen und chemischen Einwirkungen weitestgehend geschützt. Die Metallschicht 16 verleiht der Barriereschicht einen metallischen Glanz und wird insbesondere zur Erzielung optisch dekorativer Wirkungen an Stelle von transparenten Al₂O₃-Schichten verwendet.

Auf die Schicht 18 ist abschließend eine weitere Einzelschicht 22 aufgetragen, die eine zusätzliche Dekorativschicht darstellt. Die Dicke dieser aus einem Metall oder Metallegierungen der Elemente Aluminium, Kupfer, Zink bestehende aufgedampfte Schicht 22 beträgt ca. 10 nm bis 500 nm, vorzugsweise 30 nm bis 50 nm.

### Bezugszeichenliste

- 2: Kunststoffsubstrat
- 3: Barriereschichtensystem
- 4: Haftschicht, erste Einzelschicht
- 5: Barriereschicht, zweite Einzelschicht
- 6: Haftschicht
- 7: Substrataußenfläche
- 8: Barriereschicht
- 10: Deckschicht, Schutzschicht, dritte Einzelschicht
- 12: Barriereschichtensystem
- 14: Haftschicht, erste Einzelschicht
- 16: Barriereschicht
- 18: Deckschicht, Schutzschicht
- 20: Schichtensystem
- 22: Einzelschicht, Dekorationsschicht

## Patentansprüche

1. Verfahren zur Herstellung eines optisch transparenten Barriereschichtensystems für gasförmige und/oder flüssige Substanzen, welches auf Substraten, insbesondere auf Kunststoffsubstraten mittels eines plasmagestützten Gasphasenabscheideverfahrens aufgetragen wird und Silizium enthält, **dadurch gekennzeichnet**, daß das Barriereschichtensystem (3,12,20) mindestens zwei jeweils optisch transparente Einzelschichten (4,5; 6,8; 14,16) umfaßt, welche nacheinander auf dem Substrat (2) abgeschieden werden und daß die zuerst abgeschiedene Einzelschicht (4,6,14) auf der Substratoberfläche (7) als Siliziumoxidschicht SiOₓ mit einer stöchiometrischen Zusammensetzung von x < 2 und in einer Schichtdicke d₁ < 500 nm abgeschieden wird und daß nachfolgend zur ersten Einzelschicht (4,6,14) eine zweite, mindestens eine Metalloxidverbindung aufweisende Einzelschicht (5,8,16) in einer Schichtdicke d₂< 500 nm abgeschieden wird.

2. Verfahren nach Anspruch 1, **dadurch gekennzeichnet**, daß die erste Einzelschicht (4,6,14) in einer Schichtdicke d₁ < 20 nm abgeschieden wird.

3. Verfahren nach Anspruch 1, **dadurch gekennzeichnet**, daß die zweite Einzelschicht (5,8,16) in einer Schichtdicke d₂ zwischen 30 nm und 50 nm abgeschieden wird.

4. Verfahren nach mindestens einem der Ansprüche 1 bis 3, **dadurch gekennzeichnet**, daß auf die zweite Einzelschicht (8) eine weitere, Siliziumoxidanteile aufweisende dritte Einzelschicht (10,18) in einer Schichtdicke d₃ < 500 nm als Schutzschicht abgeschieden wird.

5. Verfahren nach Anspruch 4, **dadurch gekennzeichnet**, daß die Schutzschicht (10,18) in einer Schichtdicke d₃ < 20 nm abgeschieden wird.

6. Verfahren nach mindestens einem der Ansprüche 1 bis 5, **dadurch gekennzeichnet**, daß die Einzelschichten (4,5,6,8,10,14,16) durch Aufdampfen von jeweils in einem Tiegel erwärmten und eingeschmolzenen Schichtkomponentenmaterial in einer Unterdruckatmosphäre mit einem Druck p von p < 2*10⁻² mbar unter Verwendung eines anodischen Lichtbogens, welcher zwischen einer Kathode und dem als Anode geschalteten Tiegel erzeugt wird und durch Zugabe eines oxydierenden Gases in die Unterdruckatmosphäre reaktiv abgeschieden werden.

7. Verfahren nach Anspruch 6, **dadurch gekennzeichnet**, daß als Reaktivgas Sauerstoff verwendet wird.

8. Verfahren nach Anspruch 6 und/oder 7, **dadurch gekennzeichnet**, daß das Kathodenmaterial aus mindestens einem der Elemente oder Legierungen der Gruppe Kupfer, Zink, Magnesium, Zinn, Chrom ausgewählt wird.

9. Schichtensystem, welches mindestens zwei auf einem Substrat, vorzugsweise einem Kunststoffsubstrat nacheinander abgeschiedene, jeweils optisch transparente Einzelschichten umfaßt und wobei mindestens eine der Einzelschichten Siliziumanteile enthält, nach mindestens einem der Verfahrensansprüche 1 bis 8, **gekennzeichnet durch** eine erste auf dem Substrat (2) aufgebrachte Siliziumoxidschicht SiOₓ, welche eine stöchiometrische Zusammensetzung x < 2 und eine Schichtdicke d₁ < 500 nm aufweist und eine auf die erste Schicht (4,6,14) abgeschiedene zweite, Metalloxidverbindungen enthaltende Einzelschicht (5,8,16) umfaßt, wobei die zuerst aufgetragene Einzelschicht (4,6,14) eine Haftfunktionsschicht ist, mittels welcher die Haftfestigkeit der zweiten Einzelschicht (5,8,16) auf dem Substrat (2) erhöht wird und wobei die zweite Einzelschicht (5,8,16) die Permeation und/oder Diffusion von gasförmigen und/oder flüssigen Substanzen durch die beschichtete Substratgrenzfläche verhindert und als Barriereschicht wirkt.

10. Schichtensystem nach Anspruch 9, **dadurch gekennzeichnet**, daß die zweite Schicht (5,8,16) aus Aluminiumoxid (Al₂O₃) besteht und eine Schichtdicke von 10 nm bis 500 nm, vorzugsweise von 30 nm bis 50 nm besitzt.

11. Schichtensystem nach Anspruch 9 und/oder 10, **dadurch gekennzeichnet**, daß eine auf die zweite Schicht (8,16) abgeschiedene dritte Schicht (18) vorgesehen ist, welche aus einer Siliziumverbindung besteht und eine Schichtdicke d₃ < 500 nm aufweist.

12. Schichtensystem nach mindestens einem der Ansprüche 9 bis 11, **dadurch gekennzeichnet**, daß die dritte Schicht (18) eine Schichtdicke d₃ < 20 nm aufweist.

13. Schichtensystem nach mindestens einem der Ansprüche 9 bis 12, **dadurch gekennzeichnet**, daß die dritte Schicht (10,18) aus Siliziumoxid (SiOₓ) mit der stöchiometrischen Zusammensetzung 1 ≤ x < 2 besteht und als Schutzschicht vorgesehen ist.

14. Schichtensystem nach mindestens einem der Ansprüche 9 bis 13, **dadurch gekennzeichnet**, daß das Substrat Polyethylenterefthalat (PET) aufweist.

15. Schichtensystem nach mindestens einem der Ansprüche 9 bis 14, **dadurch gekennzeichnet**, daß das Substrat (2) als gasförmige und/oder flüssige Substanzen aufnehmender Behälter ausgeformt ist und wobei das Schichtensystem (12,20) auf der Außenwandfläche des Behälters aufgetragen ist.
